(19) Europäisches Patentamt / European Patent Office / Office européen des brevets

(11) **EP 2 469 236 B1**

(12) **FASCICULE DE BREVET EUROPEEN**

(45) Date de publication et mention
de la délivrance du brevet:
**16.11.2016 Bulletin 2016/46**

(51) Int Cl.:
**G01D 3/036** (2006.01)

(21) Numéro de dépôt: **11194170.4**

(22) Date de dépôt: **16.12.2011**

(54) **Dispositif de neutrodynage actif.**

Vorrichtung zur aktiven Entkoppelung

Active neutralisation device.

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.12.2010 FR 1005079**

(43) Date de publication de la demande:
**27.06.2012 Bulletin 2012/26**

(73) Titulaire: **Thales**
**92400 Courbevoie (FR)**

(72) Inventeur: **Bouyat, Stéphane**
**86130 Saint-Cyr (FR)**

(74) Mandataire: **Brunelli, Gérald**
**Marks & Clerk France**
**Immeuble Visium**
**22, avenue Aristide Briand**
**94117 Arcueil Cedex (FR)**

(56) Documents cités:
**EP-A1- 1 426 771     WO-A1-2007/062967**

• **TAHAR J ET AL: "Microwave life detector for
buried victims using neutrodyning loop based
system", JOURNAL OF APPLIED GEOPHYSICS,
ELSEVIER, AMSTERDAM, NL, vol. 68, no. 3, 1
juillet 2009 (2009-07-01), pages 371-379,
XP026150273, ISSN: 0926-9851, DOI:
10.1016/J.JAPPGEO.2009.02.011 [extrait le
2009-03-10]**

**Description**

La présente invention concerne un dispositif de neutrodynage actif. Elle s'applique par exemple dans le domaine de l'électronique de traitement de l'information des capteurs et des détecteurs capacitifs.

L'électronique de traitement de l'information des capteurs et des détecteurs capacitifs peut nécessiter l'emploi d'une porteuse Haute Fréquence (HF) comme support de l'information utile, de l'ordre de 10 à 20 fois la fréquence du signal utile. Cette porteuse HF doit ensuite être éliminée ou réduite au niveau des étages d'amplification et de démodulation du signal utile à traiter. Le neutrodynage consiste à injecter, au niveau de ces étages, un signal en opposition de phase avec la porteuse HF. Le niveau du signal en opposition de phase permet d'annuler ou de réduire la porteuse HF et ainsi de favoriser le rapport signal à bruit et d'éviter la saturation des étages d'amplification et de démodulation du signal utile.

Comme explicité dans la suite de la présente demande, les techniques actuelles de neutrodynage nécessitent un réglage au travers de potentiomètres ou de dispositifs similaires. D'une part, ce réglage doit être réalisé sur chaque capteur ou détecteur de manière individuelle, car le niveau à régler est souvent directement lié à des capacités parasites mal maîtrisées dans le capteur ou le détecteur. D'autre part, ce réglage étant effectué une fois pour toutes lors des phases initiales de production du capteur ou du détecteur, toute variation ultérieure ou dérive ne peut pas être compensée.

Le document WO 2007/062967 A1 décrit un dispositif de neutrodynage selon l'état de la technique. L'invention a notamment pour but de mettre en oeuvre un neutrodynage actif qui s'adapte en permanence de manière à optimiser le niveau résiduel de la porteuse HF. A cet effet, l'invention a pour objet un dispositif de neutrodynage d'un signal obtenu par transposition à une haute fréquence d'un signal utile fourni par un équipement, ledit équipement ayant une capacité parasite $C_{parasite}$ qui varie dans le temps. Le dispositif comporte une capacité de neutrodynage $C_{neut}$ et des moyens à gain G ajustable, ainsi que des moyens pour asservir le gain G de telle sorte que, en permanence,

$$G \times C_{neut} = C_{parasite}.$$

Par exemple, les moyens à gain G ajustable peuvent inclure un transistor de type JFET, les moyens pour asservir pouvant commander ledit transistor en tension de manière à ajuster son gain. L'obtention de l'asservissement du gain est connu de l'état de la technique et des modes de réalisation de cet asservissement sont présents dans différents dispositifs. Par exemple les récepteurs de télévision ou de radio comportent un dispositif d'ajustement automatique du gain (l'abréviation anglaise AGC pour « automatic gain control » est également utilisée dans l'état de la technique pour désigner ce dispositif) permettant de s'adapter aux variations de puissance des ondes radio reçues par le récepteur. Un autre exemple est l'oscillateur de type pont de Wien dans lequel le gain est ajusté pour avoir une condition d'auto-oscillation.

Avantageusement, les moyens pour asservir peuvent inclure des moyens pour transposer le signal utile à la haute fréquence, des moyens pour éliminer la composante non continue du signal transposé et des moyens pour corriger la valeur courante du gain G à partir de la composant continue du signal transposé.

Avantageusement là encore, les moyens pour corriger peuvent inclure des moyens pour estimer, dans la composante continue du signal transposé à la haute fréquence, une composante proportionnelle à la différence entre le niveau de haute fréquence dû à la valeur courante de neutrodynage $G \times C_{neut}$ et le niveau de haute fréquence dû à la valeur courante de la capacité parasite $Cp_{arasite}$, les moyens pour corriger pouvant déduire de cette composante proportionnelle la correction à effectuer sur le gain G.

Par exemple, les moyens pour estimer la composante proportionnelle à la différence entre le niveau de haute fréquence dû à la valeur courante de neutrodynage $G \times C_{neut}$ et le niveau de haute fréquence dû à la valeur courante de la capacité parasite $Cp_{arasite}$ peuvent inclure un filtre passe-bas et/ou un intégrateur.

Par exemple, les moyens pour éliminer la composante non continue du signal transposé peuvent inclure un filtre CIC.

Dans un mode de réalisation, les moyens pour asservir peuvent être implémentés au sein d'un FPGA.

L'équipement peut être une cellule MEMS, par exemple un gyromètre.

L'invention a encore pour principaux avantages qu'elle permet, en mode de fonctionnement sous gradient thermique et avec des effets de dérive à long terme, de garantir les performances de bruit.

D'autres caractéristiques et avantages de l'invention apparaîtront à l'aide de la description qui suit faite en regard de dessins annexés qui représentent :

- la figure 1, par un synoptique, les principes du neutrodynage passif selon l'art antérieur;
- la figure 2, par un synoptique, les principes du neutrodynage actif selon l'invention;
- la figure 3, par un synoptique, les principes de fonctionnement d'une autorité de commande selon l'invention;

- les figures 4 et 5, par des synoptiques, des exemples de réalisation selon l'invention.

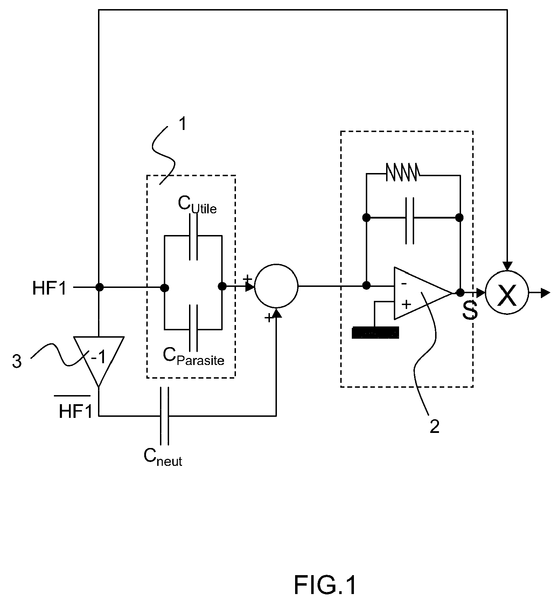

La figure 1 illustre par un synoptique un dispositif de neutrodynage passif selon l'art antérieur dans le cas d'une cellule MEMS 1 (Microsystèmes Electro-Mécaniques), qu'il s'agisse d'une cellule capteur ou d'une cellule détecteur, cette cellule 1 ayant une capacité utile $C_{utile}$ et une capacité parasite $C_{parasite}$. Une porteuse *HF1* est nécessaire comme support aux signaux de détection, la porteuse *HF1* ayant une fréquence de l'ordre de 10 à 20 fois la fréquence de ces signaux de détection, car les précisions de phases recherchées dans les opérations de modulation/démodulation sont comprises entre 0.001 ° et 0.01 ° suivant les applications visées. De telles précisions sont inaccessibles si on ne sépare pas le signal de détection du signal d'excitation, car le signal d'excitation va venir faire tourner la phase de la détection, les deux signaux étant en quadrature. La séparation spectrale par porteuse HF est une des techniques qui permet de traiter cette problématique. Elle nécessite cependant d'avoir recours à une opération de neutrodynage en injectant la porteuse en opposition de phase $\overline{HF1}$ sur l'amplificateur de charge 2. Cette opération de neutrodynage est avant tout nécessaire afin que l'amplificateur de charge 2 ne sature pas. En effet, la porteuse HF est choisie avec une amplitude suffisamment élevée pour garantir un niveau de détection suffisant et ne pas pénaliser le rapport signal à bruit. L'opération de neutrodynage permet avant tout d'éviter la saturation de l'amplificateur de charge 2, mais elle a d'autres impacts sur les performances de la cellule 1. En effet, si on note $\eta_{HF}$ le bruit du générateur HF qui génère la porteuse *HF*1, celle-ci génère deux à trois fois ce bruit en sortie de l'amplificateur de charge 2. Ceci dégrade fortement les performances de bruit. Le principe du neutrodynage est d'injecter un signal en opposition de phase $\overline{HF1}$, donc avec un bruit corrélé $-\eta$HF, venant compenser le bruit dû au générateur HF, ceci dans des ratios dépendant de la qualité de neutrodynage et de la symétrie entre la porteuse *HF1* et le signal en opposition de phase $\overline{HF1}$. On peut noter ici l'intérêt évident de générer la porteuse *HF*1 et le signal en opposition de phase $\overline{HF1}$ avec un amplificateur à sorties différentielles ou tout dispositif permettant de garantir la réelle opposition de phase et donc une bonne corrélation de bruit.

Comme explicité précédemment, le neutrodynage était jusqu'à présent assuré par un réglage capacitif ou résistif réalisé en usine, en utilisant simplement un composant 3 de gain fixe égal à -1 et une capacité de neutrodynage $C_{neut}$ telle que $C_{neut} = C_{parasite}$. Outre le fait que ces opérations de réglage sont délicates ou coûteuses à industrialiser, elles présentent également l'inconvénient de ne pas adapter le neutrodynage pendant le fonctionnement de l'équipement. Par conséquent, en mode de fonctionnement sous gradient thermique et avec des effets de dérive à long terme, les performances de bruit ne peuvent pas être maintenues.

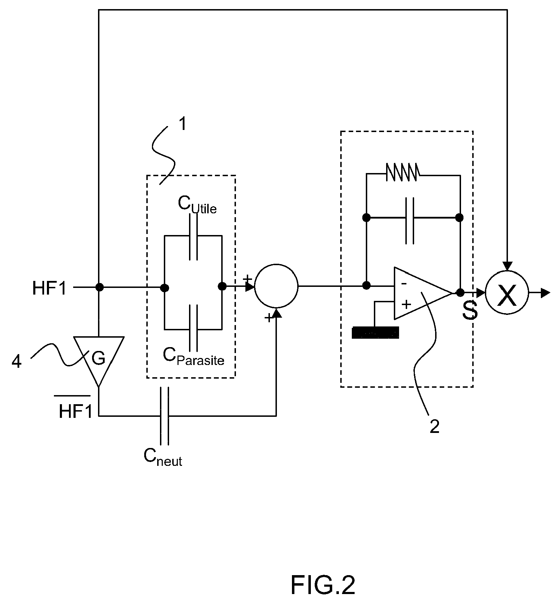

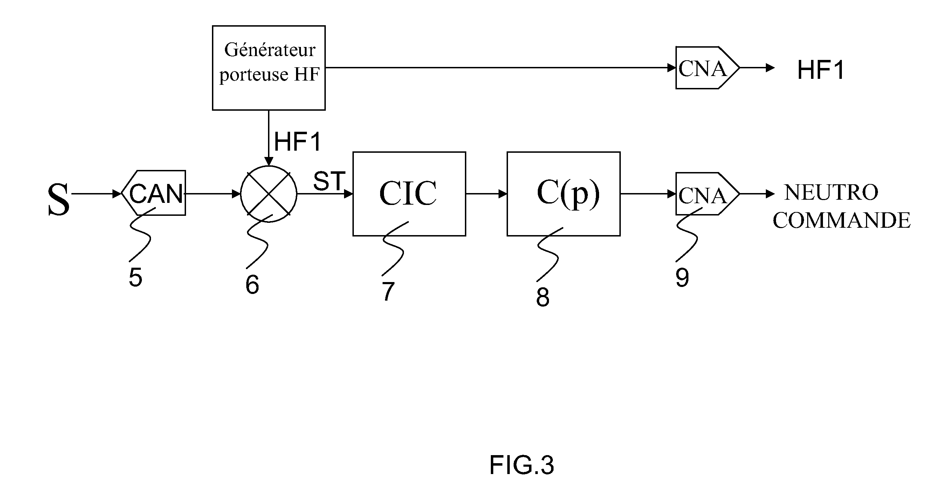

Les figures 2 et 3 illustrent par des synoptiques des principes de base de l'invention. Sur la figure 2, le composant 3 de gain fixe égal à -1 est remplacé par un composant 4 à gain G ajustable. Dans un mode de réalisation préférentiel, on peut choisir $C_{neut} \geq C_{parasite}$ et faire varier G entre -1 et 0 de manière à maintenir l'égalité $C_{neut} \times G = C_{parasite}$. Il faut bien comprendre que le composant 4 à gain G ajustable peut être implémenté de différentes manières. Par exemple, il peut s'agir d'une JFET (Junction Field Effect Transistor) utilisé comme potentiomètre, comme dans l'exemple de réalisation qui suit. Mais tout autre composant dont le gain peut être asservi peut être utilisé.

Le signal S en sortie de l'ampli de charge 2 peut s'écrire conformément à l'équation (1) qui suit :

$$S = A_{HF}.\sin(\omega_{HF}.t) \times \left[ \left( A_{cp} + A_{cu}.\sin(\omega_{cu}.t) \right) - A_{neut} \right] \qquad (1)$$

Où :

$A_{HF}$ : amplitude de la porteuse *HF*1 ;
$\omega_{HF}$ : pulsation de la porteuse *HF*1 ;
$A_{cp}$ : niveau de HF dû à la présence de $C_{parasite}$ ;
$A_{cu}$ : taux de modulation du signal utile dû à la variation de $C_{utile}$ ;
$\omega_{cu}$ : pulsation du signal utile ;
$A_{neut}$ : niveau de neutrodynage, qui est un élément de commande de l'asservissement.

Le neutrodynage est optimal lorsque $A_{neut} = A_{cp}$ : spectralement il ne reste que les bandes latérales, la porteuse HF a disparu. Si l'on développe (1), on obtient :

$$S = \left[ \left( A_{cp} - A_{neut} \right) A_{HF}.\sin(\omega_{HF}.t) \right] + A_{HF}.\frac{A_{cu}}{2} \times \left[ \cos((\omega_{HF} - \omega_{cu}).t) - \cos((\omega_{HF} + \omega_{cu}).t) \right]$$

Que l'on peut réécrire sous la forme :

$$S = \left[ \left( A_{cp} - A_{neut} \right) A_{HF} . \sin(\omega_{HF} . t) + A_{cu} . \cos\left( (\omega_{HF} - \omega_{cu}) . t \right) - A_{cu} . \cos\left( (\omega_{HF} + \omega_{cu}) . t \right) \right]$$

Afin de réaliser l'asservissement du composant 4 à gain G ajustable, il vaut mieux observer le signal S après transposition comme illustré par la figure 3. La figure 3 illustre par un synoptique une autorité de commande selon l'invention du composant 4 à gain G ajustable via une commande NEUTRO_COMMANDE, de manière à couvrir les pires cas de variations et de dispersions des capacités de la cellule MEMS 1. Tout d'abord, le signal S analogique S peut être convertit en un signal numérique par un convertisseur analogique-numérique 5. Puis, on réalise une transposition de fréquence en multipliant grâce à un multiplieur 6 le signal S par la porteuse *HF*1, de manière à ramener autour de 0 hertz les bandes latérales contenant le signal utile. Soit *ST* le signal après transposition :

$$ST = S \times \sin(\omega_{HF} . t)$$

$$ST = \left[ \left( A_{cp} - A_{neut} \right) A_{HF} \middle/ 2 \right] - \left[ \left( A_{cp} - A_{neut} \right) A_{HF} \middle/ 2 \right] . \cos(2 . \omega_{HF} . t)$$
$$+ A_{cu} \middle/ 2 . \sin\left( (2 . \omega_{HF} - \omega_{cu}) . t \right) - A_{cu} \middle/ 2 . \sin\left( (2 . \omega_{HF} + \omega_{cu}) . t \right) + A_{cu} . \sin(\omega_{cu} . t) \qquad (2)$$

Dans (2) ci-dessus, on constate la présence de termes en $2.\omega_{HF}.t$ dont la composante continue est nulle. Ils ne présentent pas d'intérêt d'un point de vue traitement peuvent être éliminés par filtrage. Par exemple, un filtre 7 de type « Cascaded Integrator Comb » (CIC) peut être utilisé comme filtre décimateur, car il permet d'éliminer efficacement ces termes.

Dans (2) ci-dessus, on constate aussi la présence du terme $A_{cu}.sin(\omega_{cu}.t)$ : c'est le signal utile à traiter par le traitement I/Q des boucles d'asservissements de la cellule MEMS.

Mais on voit également apparaître un terme continu en $\left[ \left( A_{cp} - A_{neut} \right) A_{HF} \middle/ 2 \right]$ : ce terme est particulièrement intéressant, car il permet d'avoir une image du résidu de neutrodynage. En effet, il est directement proportionnel à $(A_{cp} - A_{neut})$ que l'on cherche à annuler: ce terme est présent avant et après le filtre 7, car les filtres CIC conservent la composante continue. D'autres types de filtres peuvent être utilisés à la place du filtre CIC 7, dès lors qu'ils conservent la composante continue. L'invention propose d'utiliser la composante continue de l'information, après changement de fréquence et filtrage, pour asservir les valeurs de neutrodynages grâce à un correcteur en boucle fermée 8. Le signal de commande est au préalable converti en analogique par un convertisseur numérique-analogique 9, afin de fournir la commande NEUTRO_COMMANDE permettant de commander le composant 4 à gain G ajustable.

Concernant le correcteur d'asservissement 8, celui-ci peut être réalisé à l'aide d'un filtre passe bas, par exemple avec une constante de temps de 0.05 seconde, suivi d'un simple intégrateur, par exemple avec une constante de temps de 2 secondes. Le choix d'un intégrateur avec une constante de temps lente vis à vis du filtre passe-bas permet de ne pas voir le pôle qui déstabiliserait la boucle. En fonction du type de correcteur choisi, la présence du filtre passe bas est optionnelle, un intégrateur pouvant servir de filtrage passe-bas.

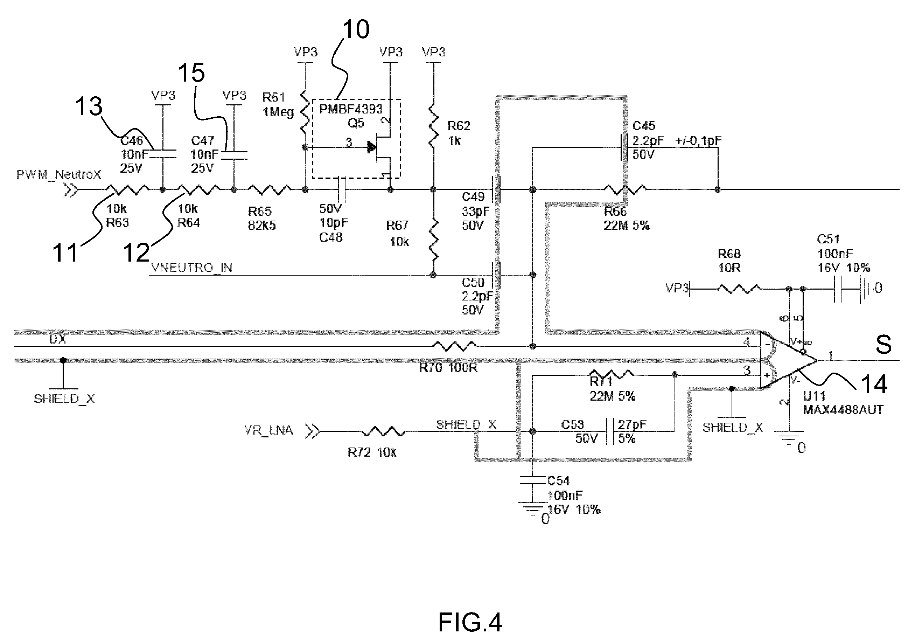

La figure 4 illustre par un synoptique un exemple de réalisation du neutrodynage actif selon la présente invention dans un gyromètre MEMS à partir d'un transistor 10 de type JFET. Dans le présent exemple de réalisation, il s'agit d'un JFET à canal N de modèle PMBF4393 distribué par Philips. Le signal utile est à 11 kHz et la porteuse à 200 kHz. La présente invention propose de réaliser une autorité de commande en tension du JFET 10 de manière à couvrir les pires cas de variations et de dispersions des capacités des cellules MEMS. Dans le présent exemple de réalisation, une tension de commande est appliquée sur la grille 3 du JFET 10 par filtrage d'un signal PWM_NeutroX modulé en largeur de bande (Pulse Width Modulation). Le signal PWM_NeutroX est issu d'une plateforme de traitement numérique non représentée sur la figure 4. Le filtrage du signal PWM_NeutroX est réalisé par des résistances 11, 12 et des capacités 13 et 15.

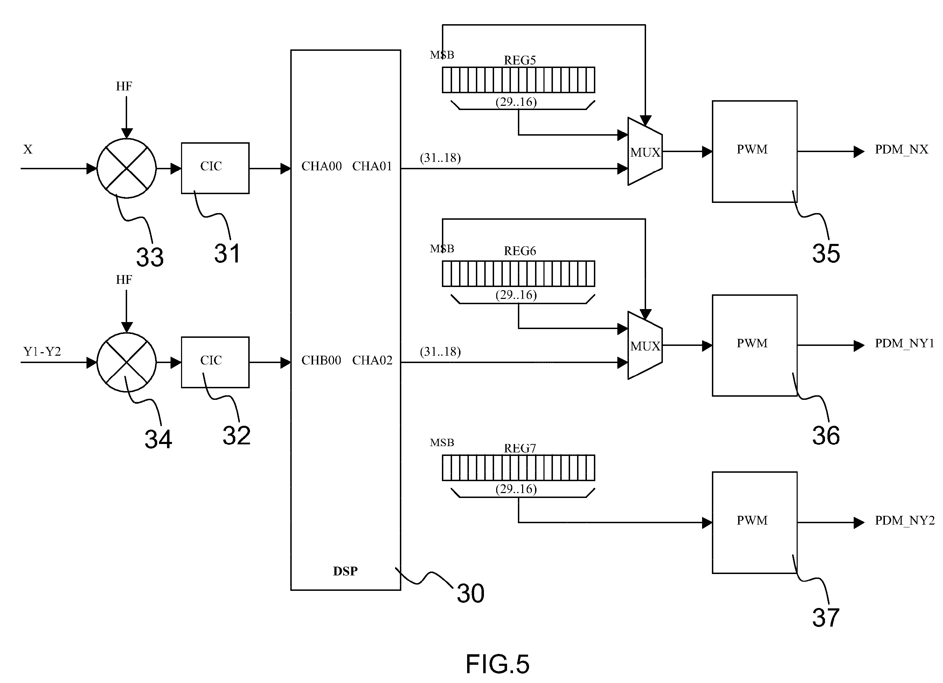

La figure 5 illustre par un synoptique un exemple de réalisation d'une plateforme de traitement selon la présente invention, implémentée au sein d'un FPGA (Field Programmable Gate Array). La plateforme reçoit en entrées des signaux X et Y1-Y2. En effet, dans le présent exemple de réalisation plusieurs signaux de la cellule MEMS sont traités. Elle comporte notamment des multiplieurs 33 et 34, des filtres CIC 31 et 32, ainsi qu'un DSP 30 (Digital Signal Processor).

Une commande PDM_NX (Pulse Density Modulation) correspond soit à une commande manuelle par un registre REG5, soit à une commande automatique par la voie n°1 du canal A du DSP (CHA01). C'est la commande du JFET 10 voie X correspondant au PWM_NeutroX de la figure 4. Une commande PDM_NY1 correspond soit à une commande manuelle par un registre REG6, soit à une commande automatique par la voie n°2 du canal A du DSP (CHA02). C'est la commande de neutrodynage voie Y1. Une commande PDM_NY2 correspond à une commande manuelle par un registre REG7 uniquement. C'est la commande de neutrodynage voie Y2. L'asservissement va trouver son point d'équilibre, mais un préréglage usine sur la voie Y2 est recommandé.

Il faut bien comprendre que, même si le présent mode de réalisation a été implémenté au sein d'un FPGA, d'autres modes de réalisation de l'invention sont possibles.

**Revendications**

1. Dispositif de neutrodynage d'un signal obtenu par transposition à une haute fréquence d'un signal utile fourni par un équipement (1), ledit équipement (1) ayant une capacité parasite $C_{parasite}$ qui varie dans le temps, le dispositif étant **caractérisé en ce qu'**il comporte une capacité de neutrodynage $C_{neut}$ et des moyens (4) à gain G ajustable, le dispositif comportant des moyens pour asservir le gain G de telle sorte que, en permanence, $GxC_{neut}=C_{parasite}$, les moyens pour asservir incluant :

   - des moyens pour transposer le signal utile à la haute fréquence ;
   - des moyens pour éliminer la composante non continue du signal transposé ; et
   - des moyens (8) pour corriger la valeur courante du gain G à partir de la composante continue du signal transposé.

2. Dispositif selon la revendication 1, **caractérisé en ce que** les moyens à gain G ajustable incluent un transistor de type JFET (10), les moyens pour asservir commandant ledit transistor en tension de manière à ajuster son gain.

3. Dispositif selon la revendication 1 ou 2, **caractérisé en ce que** les moyens (8) pour corriger incluent des moyens pour estimer, dans la composante continue du signal transposé à la haute fréquence, une composante proportionnelle à la différence entre le niveau de haute fréquence dû à la valeur courante de neutrodynage $GxC_{neut}$ et le niveau de haute fréquence dû à la valeur courante de la capacité parasite $C_{parasite}$, les moyens pour corriger déduisant de cette composante proportionnelle la correction à effectuer sur le gain G.

4. Dispositif selon la revendication 3, **caractérisé en ce que** les moyens pour estimer la composante proportionnelle à la différence entre le niveau de haute fréquence dû à la valeur courante de neutrodynage GxCneut et le niveau de haute fréquence dû à la valeur courante de la capacité parasite Cparasite incluent un filtre passe-bas et/ou un intégrateur.

5. Dispositif selon la revendication 1, **caractérisé en ce que** les moyens pour éliminer la composante non continue du signal transposé incluent un filtre CIC pour "Cascaded Integrator Comb" en langue anglaise (7).

6. Dispositif selon la revendication 1, **caractérisé en ce que** les moyens pour asservir sont implémentés au sein d'un FPGA pour "Field Programmable Gate Array" en langue anglaise.

7. Dispositif selon la revendication 1, **caractérisé en ce que** l'équipement (1) est une cellule MEMS pour Microsystèmes Electro-Mécaniques,

8. Dispositif selon la revendication 7, **caractérisé en ce que** la cellule MEMS pour Microsystèmes Electro-Mécaniques est un gyromètre

**Patentansprüche**

1. Vorrichtung zur Neutralisierung eines Signals, erhalten durch Transposition, auf eine Hochfrequenz, eines von einem Gerät (1) gelieferten Nutzsignals, wobei das Gerät (1) eine parasitäre Kapazität $C_{parasitär}$ aufweist, die im Laufe der Zeit variiert, wobei die Vorrichtung **dadurch gekennzeichnet ist, dass** sie eine Neutralisierungskapazität $C_{neut}$ und Mittel (4) mit einstellbarer Verstärkung G umfasst, wobei die Vorrichtung Mittel umfasst, um die Verstärkung G in solcher Weise zu regeln, dass, ständig, $GxC_{neut}=C_{parasitär}$, wobei die Mittel zum Regeln einschließen:

   - Mittel zum Transponieren des Nutzsignals auf die Hochfrequenz;
   - Mittel zum Eliminieren der Nicht-DC-Komponente des transponierten Signals; und

- Mittel (8) zum Korrigieren des aktuellen Werts der Verstärkung G ausgehend von der DC-Komponente des transponierten Signals.

**2.** Vorrichtung nach Anspruch 1, **dadurch gekennzeichnet, dass** die Mittel mit einstellbarer Verstärkung G einen Transistor vom Typ JFET (10) einschließen, wobei die Mittel zum Regeln den Transistor spannungssteuern, um seine Verstärkung einzustellen.

**3.** Vorrichtung nach Anspruch 1 oder 2, **dadurch gekennzeichnet, dass** die Mittel (8) zum Korrigieren Mittel zum Schätzen, in der DC-Komponente des auf die Hochfrequenz transponierten Signals, eine Komponente einschließen, die proportional ist zur Differenz zwischen dem durch den aktuellen Neutralisierungswert $GxC_{neut}$ bedingten Hochfrequenzniveau und dem durch den aktuellen Wert der parasitären Kapazität $C_{parasitär}$ bedingten Hochfrequenzniveau, wobei von dieser proportionalen Komponente die Mittel zum Korrigieren die an der Verstärkung G vorzunehmende Korrektur ableiten.

**4.** Vorrichtung nach Anspruch 3, **dadurch gekennzeichnet, dass** die Mittel zum Schätzen der Komponente, die proportional ist zur Differenz zwischen dem durch den aktuellen Neutralisierungswert $GxC_{neut}$ bedingten Hochfrequenzniveau und dem durch den aktuellen Wert der parasitären Kapazität $C_{parasitär}$ bedingten Hochfrequenzniveau, ein Tiefpassfilter und/oder einen Integrator einschließen.

**5.** Vorrichtung nach Anspruch 1, **dadurch gekennzeichnet, dass** die Mittel zum Eliminieren der Nicht-DC-Komponente des transponierten Signals ein CIC-, für "Cascaded-Integrator-Comb" in englischer Sprache, Filter (7) einschließen.

**6.** Vorrichtung nach Anspruch 1, **dadurch gekennzeichnet, dass** die Mittel zum Regeln innerhalb eines FPGA, für "Field Programmable Gate Array" in englischer Sprache, implementiert sind.

**7.** Vorrichtung nach Anspruch 1, **dadurch gekennzeichnet, dass** das Gerät (1) eine MEMS-, für "elektromechanische Mikrosysteme", Zelle ist.

**8.** Vorrichtung nach Anspruch 7, **dadurch gekennzeichnet, dass** die MEMS-, für "elektromechanische Mikrosysteme", Zelle ein Gyrometer ist.

**Claims**

**1.** A device for neutralising a signal obtained by transposition to a high frequency of a useful signal supplied by a piece of equipment (1), said piece of equipment (1) having a parasitic capacitance $C_{parasitic}$ that varies over time, the device being **characterised in that** it comprises a neutralisation capacitance $C_{neut}$ and means (4) with adjustable gain G, the device comprising means for controlling the gain G such that, permanently, $GXC_{neut}=C_{parasitic}$, the control means including :

- means for transposing the useful signal to the high frequency;
- means for eliminating the non-DC component of the transposed signal; and
- means (8) for correcting the current value of the gain G on the basis of the DC component of the transposed signal.

**2.** The device according to Claim 1, **characterised in that** the means with adjustable gain G include a JFET-type transistor (10), the control means controlling said transistor voltage so as to adjust its gain.

**3.** The device according to Claim 1 or 2, **characterised in that** the correction means (8) include means for estimating, within the DC component of the signal transposed to the high frequency, a component proportional to the difference between the level of high frequency due to the current neutralisation value $GxC_{neut}$ and the level of high frequency due to the current value of the parasitic capacity $C_{parasitic}$, the correction means deducing, from this proportional component, the correction to be applied to the gain G.

**4.** The device according to Claim 3, **characterised in that** the means for estimating the component proportional to the difference between the level of high frequency due to the current neutralisation value $GxC_{neut}$ and the level of high frequency due to the current value of the parasitic capacitance $C_{parasitic}$ include a low-pass filter and/or an integrator.

**5.** The device according to Claim 1, **characterised in that** the means for eliminating the non-DC component of the transposed signal include a CIC, or "Cascaded Integrator Comb", filter (7).

**6.** The device to Claim 1, **characterised in that** the control means are implemented within an FPGA, or "Field Programmable Gate Array".

**7.** The device according to Claim 1, **characterised in that** the piece of equipment (1) is an MEMS, or Micro-Electro-Mechanical Systems, cell.

**8.** The device according to Claim 7, **characterised in that** the MEMS, or Micro-Electro-Mechanical Systems, cell is a gyrometer.

FIG.1

FIG.2

FIG.3

EP 2 469 236 B1

FIG.4

FIG.5

**EP 2 469 236 B1**

**RÉFÉRENCES CITÉES DANS LA DESCRIPTION**

**Documents brevets cités dans la description**

- WO 2007062967 A1